# EUROPEAN PATENT SPECIFICATION

(11) **EP 3 651 557 B1**
(45) Date of publication and mention of the grant of the patent: **07.06.2023**
(21) Application number: 19206563.9
(22) Date of filing: 31.10.2019
(51) Int. Cl.: H05K 1/14, F21V 23/00

(54) **LIGHT EMITTING DIODE DEVICE**
LEUCHTDIODENVORRICHTUNG
DISPOSITIF À DIODE ÉLECTROLUMINESCENTE

(30) Priority: 07.11.2018 SE 1851380
(43) Date of publication of application: 13.05.2020
(73) Proprietor: Optoga AB, 732 31 Arboga (SE)
(72) Inventor: LARSSON, Stefan, 732 33 ARBOGA (SE)
(74) Representative: Bjerkén Hynell KB

(56) References cited:
- CN-A- 107 991 810
- US-A1- 2007 253 218
- US-A1- 2009 235 208
- US-A1- 2010 067 256
- US-A1- 2013 294 778
- US-A1- 2015 195 873

## Description

### Technical field

The present disclosure relates to a light emitting diode (LED) device and in particular a compact LED device having all functionality integrated into the device.

### Background

Today the lighting industry has opportunity to create dynamic and coherent lighting environments. There is endless technology, networks and light sources that end consumers can choose between. A system of a plurality of wirelessly connected LED devices require simplified and compact devices where all functionality is built into each LED device.

In the following some patent documents will be briefly presented, disclosing various technical solutions in this technical field.

JP-2011044401 relates to a lighting system with small size and capable of reducing efficiently electromagnetic noises. An electromagnetic shield-cum-heat sink is arranged between a control substrate, equipped with a communication control part, and a light source control part, and a light source substrate mounted with a light source part; and a through hole is installed at the end part of this electromagnetic shield-cum-heat sink. Here, a power supply wire to connect the power supply part and the light source part, and a signal wire to connect the light source control part and the light source part are inserted in the through hole.

US-2016/0302280 relates to an LED based illumination device that includes a plurality of LEDs that emit light through an output port of a housing. The LED based illumination device includes a heat sink that is in thermal contact with the plurality of LEDs. A peripheral electrical circuit board is configured to be contained within the housing, e.g., surrounding a least a portion of the heat sink.

US-2015/0338077 relates to a stand-alone "smart" luminaire component with communication capabilities, comprising an LED module on a first printed circuit board having a front face on which the LED module is located, and a second printed circuit board.

US-2008/0211369 discloses an LED module comprising four substrates where two carry LEDs and further two carry a wireless communication antenna and a controller respectively.

US-2015/0195873 discloses a lighting module, including a first printed circuit board, on which at least one light source is arranged, and a covering element which partially covers the first printed circuit board.

US-2009/0235208 discloses a lighting apparatus, which lights by emitting light through solid-state light-emitting devices using an AC power source. The lighting apparatus includes an AC to DC conversion unit that converts AC from the power source into DC.

From the above documents, it has been noticed that still further improvements are needed to meet the demands of today in particular with regard to size of the device and in achieving a device having full functionality. Thus, the object of the present invention is to achieve an improved LED device that is compact, and having all functionality integrated into the device. In particular an LED device where all safety standards set up by regulatory authorities are met.

### Summary

The above-mentioned objects are achieved by the present invention according to the independent claim.

Preferred embodiments are set forth in the dependent claims.

The present invention relates to aspects of a compact LED device having an essentially flat extension that comprises two circuit boards; a first printed circuit board (PCB) that includes drive circuitry and the LED, and a second PCB that includes various electronic circuitry. A three-dimensional layout of the circuitries of the PCBs is adapted to each other such that a compact LED device having a flat extension, i.e. having a thin thickness, is achieved and where regulatory requirements are met.

### Brief description of the drawings

Figure 1 is a schematic side view of the LED device according to the present invention.
Figure 2 is a schematic view from above of one embodiment of the LED device according to the present invention.
Figure 3 is a perspective view of one embodiment of the LED device according to the present invention.
Figure 4 is a perspective view of another embodiment the LED device according to of the present invention.

### Detailed description

The LED device will now be described in detail with references to the appended figures. Throughout the figures the same, or similar, items have the same reference signs. Moreover, the items and the figures are not necessarily to scale, emphasis instead being placed upon illustrating the principles of the invention.

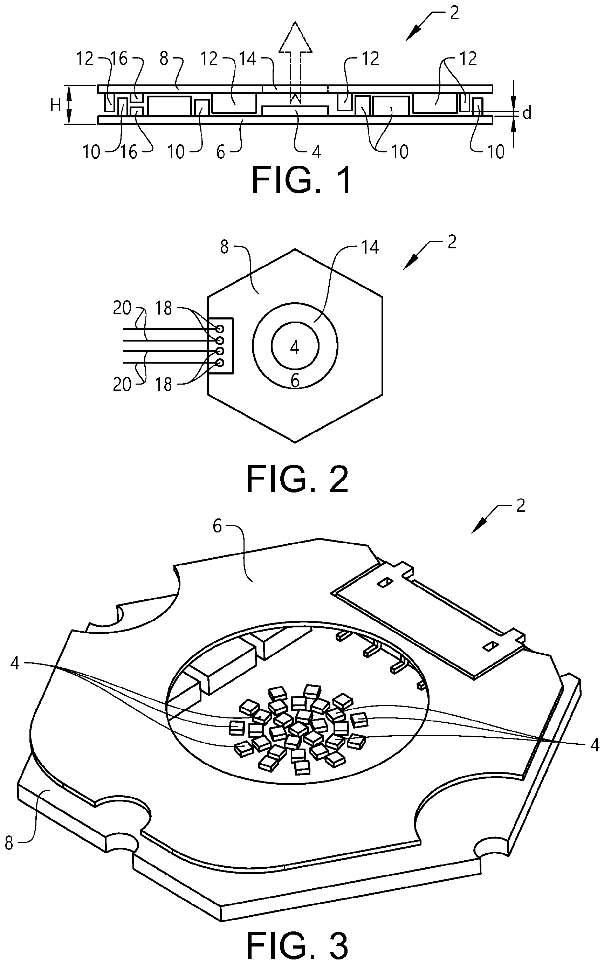

First with reference to figure 1 a schematic side view of the light emitting diode (LED) device 2 comprising at least one LED 4 is disclosed. The LED device comprises two printed circuit boards (PCBs), a first PCB 6 and a second PCB 8; the PCBs are essentially planar and have a same size and shape, and are provided with circuitry on one side. These circuitry sides are configured to face each other when the PCBs are mounted together, and that the second PCB 8 is mounted above the first PCB 6 in a parallel fashion to define the device. The shape of the PCB may be rectangular, circular, hexagonal (see figures 2 and 3), or may have any other shape.

The first PCB 6 comprises high voltage circuitry 10, e.g. 230 VAC drive circuitry, and the at least one LED 4. In the embodiment disclosed in figure 1 the LED device comprises one LED, and in the embodiment disclosed in figure 3 the LED device comprises a plurality of LEDs 4. Thus, the LED may be embodied as one or many separate LEDs mounted on the PCB. It may also be embodied as one or many so called Chip-on-board (COB) LEDs which instead is built directly on the PCB.

The at least one LED 4 being mounted to generate light in an essentially perpendicular direction in relation to the plane of the first PCB 6. The direction of light is indicated by an arrow in figure 1.

The second PCB 8 comprises various low voltage electronic circuitry 12, e.g. related to signal control and communication, and that the second PCB 8 comprises at least one opening 14 allowing light generated by the at least one LED 4 to pass through the second PCB 8. Herein, by low voltage is meant voltages/currents up to 48 V/250 mA.

The circuitries 10, 12 on the PCBs are designed in three dimensions to achieve high packing density, and the three dimensional design has resulted in three dimensional formations of the circuitries on the PCBs that are adapted to each other such that, when the PCBs are mounted together, the formations cooperate with each other by allowing high formations on one PCB to interpose with low formations on the other PCB.

Thus, the three dimensional formations are adapted to cooperate with each other such that high formations on one of the PCBs have an extension towards low formations on the other PCB on corresponding positions, i.e. between high formations on the other PCB.

As each board has been designed in three dimensions the resulting design has achieved a high packing density as parts on one board having low heights are designed to be mounted at positions that correspond to positions at the other board where parts are mounted having high heights. This may also be described by imagining a virtual plane that is parallel to both PCBs and virtually arranged between the PCBs at equal distances from each of the PCBs. Circuitries of both PCBs will then be present in the virtual plane.

The PCBs are mounted together by a distance keeping arrangements (not shown) such that a predetermined minimum distance d between the three dimensional formations on different PCBs are obtained. The arrangement consists of non-galvanic mounting members, e.g. made from plastic, and preferably arranged close to the edges of the PCBs. The predetermined minimum distance d is determined in dependence of regulatory requirements, and is in the range of 2-5 mm.

More particularly, in order to be able to build a device having 230VAC as input, and including drive circuitry, communication and processor power into a small application like an LED device, it is necessary to separate power from low voltage construction. This requirement comes from authority regulation. In particular it is for example stated that it is required to have 5 mm creep spacing and 3 mm airborne distance to the outer edge or 2.5 mm creep and 1.5 mm airborne internally within the application in class II luminaires. The LED device 2 has a flat and thin extension with a height H in the range of 5-20 mm in a perpendicular direction in relation to the planes of the PCBs. This results in an overall compact design.

The first PCB comprises a high voltage contact member 18 structured to receive high voltage driving power, e.g. 230 VAC, to the LED device via a connecting cable 20. This is illustrated in figure 2 but is applicable to all the embodiments disclosed herein.

According to the invention, a non-galvanic communication interface 16 (see figure 1) is provided to achieve a bidirectional communication channel between the high voltage circuitries and low voltage electronic circuitries on the first and second PCB, respectively. The non-galvanic communication interface is preferably an optical communication interface configured to achieve a bidirectional optical communication channel between the high voltage circuitries and low voltage electronic circuitries on said first and second PCB, respectively. The non-galvanic interface may also be implemented by a magnetic or electromagnetic interface.

According to a further embodiment the second PCB 8 comprises circuitry supporting Digital Addressable Lighting Interface (DALI) functionality.

DALI is a trademark for network-based systems that control lighting e.g. in building automation, and is an open standard alternative to Digital Signal Interface (DSI), on which it is based. Naturally, also other protocols may be used, such as KNX, 0-10V, Switchdim etc.

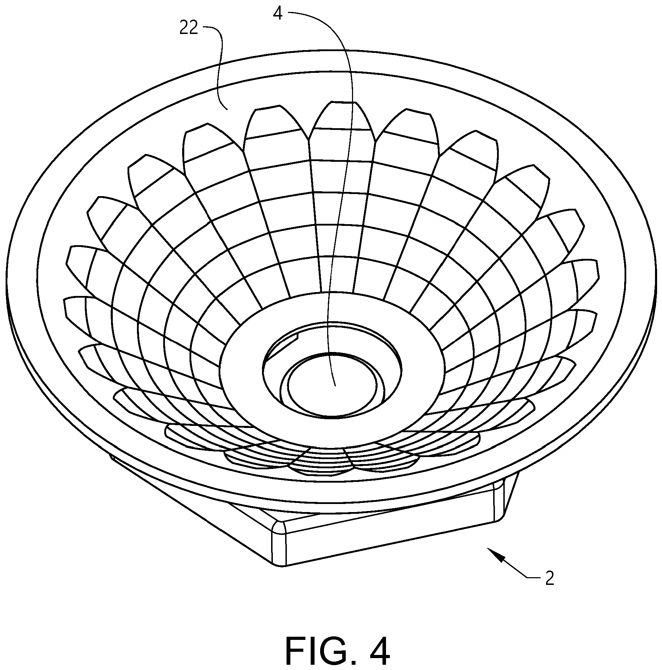

The LED device 2 is often mounted in a specific environment, or in relation to a special equipment, e.g. a medical device, or in a ceiling or wall, and is therefore preferably provided with a mounting arrangement configured to enable mounting of a housing and/or optical members, e.g. lenses, and/or reflecting members 22 at the LED device. In figure 4 is shown a LED device provided with a reflecting member 22. Thus, the LED device disclosed herein is applicable to be mounted in many different luminaire platforms, having different sizes and optics.

The present invention is not limited to the above-described preferred embodiments. Therefore, the above embodiments should not be taken as limiting the scope of the invention, which is defined by the appending claims.

## Claims

1. A light emitting diode (LED) device (2) comprising at least one LED (4), the device comprises two printed circuit boards (PCBs), a first PCB (6) and a second PCB (8); the PCBs are essentially planar and have a similar size and shape and are provided with circuitry on one side, these circuitry sides are configured to face each other if the PCBs are mounted together, and that said second PCB is mounted above said first PCB in a parallel fashion to define said device, **characterized in that**
- the first PCB (6) comprises high voltage circuitry (10), e.g. 230 VAC drive circuitry, and said at least one LED (4), wherein said at least one LED (4) being mounted to generate light in an essentially perpendicular direction in relation to the plane of the first PCB (6),
- the second PCB (8) comprises various low voltage electronic circuitry (12), e.g. related to signal control and communication, and that said second PCB (8) comprises at least one opening (14) allowing light generated by said at least one LED (4) to pass through said second PCB (8), and that
- the circuitries (10, 12) on the PCBs are designed in three dimensions to achieve high packing density, wherein said three dimensional design has resulted in three dimensional formations of the circuitries on the PCBs that are adapted to each other such that, when said PCBs are mounted together, the formations cooperate with each other by allowing high formations on one PCB to interpose with low formations on the other PCB, and that a predetermined minimum distance d between three dimensional formations on different PCBs are obtained, and wherein said LED device (2) has a flat and thin extension with a height H in the range of 5-20 mm in a perpendicular direction in relation to the planes of the PCBs, wherein the PCBs are mounted together by a distance keeping arrangement such that the predetermined minimum distance d between the three dimensional formations on different PCBs are obtained, and wherein the distance keeping arrangement consists of non-galvanic mounting members, and wherein said predetermined minimum distance d is determined in dependence of regulatory requirements, and is in the range of 2-5 mm, and that the LED device (2) further comprises a non-galvanic communication interface (16) configured to achieve a bidirectional communication channel between the high voltage circuitries and low voltage electronic circuitries on said first and second PCB, respectively, wherein the non-galvanic communication interface (16) being interposed in between the components of said low voltage and high voltage electronic circuitry, on said first and second PCB, respectively.

2. The LED device (2) according to claim 1, wherein the three dimensional formations are adapted to cooperate with each other such that high formations on one of the PCBs have an extension towards low formations on the other PCB on corresponding positions, i.e. between high formations on the other PCB.

3. The LED device (2) according to claim 1 or 2, wherein said a non-galvanic communication interface is an optical communication interface (16) configured to achieve a bidirectional optical communication channel between the high voltage circuitries and low voltage electronic circuitries on said first and second PCB, respectively.

4. The LED device (2) according to any of claims 1-3, wherein said second PCB (8) comprises circuitry supporting Digital Addressable Lighting Interface (DALI) functionality.

5. The LED device (2) according to any of claims 1-4, wherein said first PCB comprises a high voltage contact member (18) structured to receive high voltage driving power e.g. 230 VAC, to said LED device via a connecting cable (20).

6. The LED device (2) according to any of claims 1-5, comprising a mounting arrangement configured to enable mounting of a housing including optical and/or reflecting members (22) at said LED device.

## Patentansprüche

1. Leuchtdioden (LED)-Vorrichtung (2), die mindestens eine LED (4) umfasst, wobei die Vorrichtung zwei gedruckte Leiterplatten (PCBs), eine erste PCB (6) und eine zweite PCB (8), umfasst; wobei die PCBs im Wesentlichen eben sind und eine ähnliche Größe und Form aufweisen und mit einer Schaltung auf einer Seite versehen sind, wobei diese Schaltungsseiten dazu konfiguriert sind, einander zugewandt zu sein, wenn die PCBs zusammen montiert sind, und die zweite PCB oberhalb der ersten PCB auf eine parallele Weise montiert ist, um die Vorrichtung zu definieren, **dadurch gekennzeichnet, dass**
- die erste PCB (6) Hochspannungsschaltungen (10), z. B. eine 230-VAC-Ansteuerschaltung, und die mindestens eine LED (4) umfasst, wobei die mindestens eine LED (4) dazu montiert ist, Licht in einer im Wesentlichen senkrechten Richtung in Bezug auf die Ebene der ersten PCB (6) zu erzeugen,
- die zweite PCB (8) verschiedene Niederspannungs-schaltungen (12), z. B. in Bezug auf Signalsteuerung und -kommunikation, umfasst, und dass die zweite PCB (8) mindestens eine Öffnung (14) umfasst, die es ermöglicht, dass Licht, das durch die mindestens eine LED (4) erzeugt wird, durch die zweite PCB (8) hindurchgeht, und dass
- die Schaltungen (10, 12) auf den PCBs in drei Dimensionen gestaltet sind, um eine hohe Bauteildichte zu erreichen, wobei die Gestaltung mit drei Dimensionen zu dreidimensionalen Formationen der Schaltungen auf den PCBs geführt hat, die so zueinander ausgelegt sind, dass, wenn die PCBs zusammen montiert sind, die Formationen miteinander zusammenwirken, indem ermöglicht wird, das hohe Formationen auf einer PCB zwischen niedrigen Formationen auf der anderen PCB angeordnet sind, und dass ein vorbestimmter Mindestabstand d zwischen dreidimensionalen Formationen auf unterschiedlichen PCBs erhalten wird, und wobei die LED-Vorrichtung (2) eine flache und dünne Ausdehnung mit einer Höhe H im Bereich von 5-20 mm in einer senkrechten Richtung in Bezug auf die Ebenen der PCBs aufweist, wobei die PCBs durch eine Abstandhalteanordnung so zusammen montiert sind, dass der vorbestimmte Mindestabstand d zwischen den dreidimensionalen Formationen auf unterschiedlichen PCBs erhalten wird, und wobei die Abstandhalteanordnung aus nicht galvanischen Montageelementen besteht, und wobei der vorbestimmte Mindestabstand d in Abhängigkeit von regulatorischen Anforderungen bestimmt wird und im Bereich von 2-5 mm liegt, und dass die LED-Vorrichtung (2) ferner eine nicht galvanische Kommunikationsschnittstelle (16) umfasst, die dazu konfiguriert ist, einen bidirektionalen Kommunikationskanal zwischen den Hochspannungsschaltungen und den Niederspannungs-elektronikschaltungen auf der ersten bzw. zweiten PCB zu erreichen, wobei die nicht galvanische Kommunikationsschnittstelle (16) zwischen den Komponenten der Niederspannungs- und Hochspannungselektronikschaltung auf der ersten bzw. zweiten PCB angeordnet ist.

2. LED-Vorrichtung (2) nach Anspruch 1, wobei die dreidimensionalen Formationen dazu ausgelegt sind, so miteinander zusammenzuwirken, dass hohe Formationen auf einer der PCBs eine Ausdehnung in Richtung der niedrigen Formationen auf der anderen PCB an entsprechenden Positionen aufweisen, d. h. zwischen hohen Formationen auf der anderen PCB.

3. LED-Vorrichtung (2) nach Anspruch 1 oder 2, wobei die nicht galvanische Kommunikationsschnittstelle eine optische Kommunikationsschnittstelle (16) ist, die dazu konfiguriert ist, einen bidirektionalen optischen Kommunikationskanal zwischen den Hochspannungsschaltungen und den Niederspannungs-elektronikschaltungen auf der ersten bzw. zweiten PCB zu erreichen.

4. LED-Vorrichtung (2) nach einem der Ansprüche 1-3, wobei die zweite PCB (8) eine Schaltung umfasst, die eine Digital-Addressable-Lighting-Interface(DALI)-Funktionalität unterstützt.

5. LED-Vorrichtung (2) nach einem der Ansprüche 1-4, wobei die erste PCB ein Hochspannungskontaktelement (18) umfasst, das dazu strukturiert ist, eine Hochspannungsansteuerleistung, z. B. 230 VAC, für die LED-Vorrichtung über ein Verbindungskabel (20) aufzunehmen.

6. LED-Vorrichtung (2) nach einem der Ansprüche 1-5, umfassend eine Montageanordnung, die dazu konfiguriert ist, eine Montage eines Gehäuses, das optische und/oder reflektierende Elemente (22) beinhaltet, an der LED-Vorrichtung zu ermöglichen.

## Revendications

1. Dispositif à diodes électroluminescentes (LED) (2) comprenant au moins une LED (4), le dispositif comprend deux cartes de circuit imprimé (PCB), une première PCB (6) et une seconde PCB (8) ;
les PCB sont essentiellement planaires, ont une taille et une forme similaires et sont pourvues de circuits sur un côté, ces côtés à circuits sont configurés pour se faire face si les PCB sont montées ensemble, et ladite seconde PCB est montée au-dessus de ladite première PCB de manière parallèle pour définir ledit dispositif, **caractérisé en ce que**
- la première PCB (6) comprend des circuits haute tension (10), par exemple des circuits de commande 230 V. C.A., et ladite au moins une LED (4), ladite au moins une LED (4) étant montée pour générer une lumière dans une direction essentiellement perpendiculaire au plan de la première PCB (6),
- la seconde PCB (8) comprend divers circuits électroniques basse tension (12), par exemple liés à la commande et à la communication de signaux, et **en ce que** ladite seconde PCB (8) comporte au moins une ouverture (14) permettant à la lumière générée par ladite au moins une LED (4) de traverser ladite seconde PCB (8), et **en ce que**
- les circuits (10, 12) sur les PCB sont conçus en trois dimensions pour parvenir à une densité d'occupation élevée, dans lequel ladite conception tridimensionnelle a résulté en des formations tridimensionnelles des circuits sur les PCB qui sont adaptées les unes aux autres de telle sorte que, lorsque lesdites PCB sont montées ensemble, les formations coopèrent entre elles en permettant aux formations hautes sur une PCB de s'intercaler avec les formations basses sur l'autre PCB, et **en ce qu'**une distance minimale d prédéterminée entre des formations tridimensionnelles sur différentes PCB est obtenue, et dans lequel ledit dispositif à LED (2) présente une extension plane et mince d'une hauteur H dans la plage de 5 à 20 mm dans une direction perpendiculaire par rapport aux plans des PCB, dans lequel les PCB sont montées ensemble selon un agencement à maintien de distance de telle sorte que la distance minimale prédéterminée d entre les formations tridimensionnelles sur différentes PCB soit obtenue, et dans lequel l'agencement à maintien à distance est constitué d'éléments de montage non galvaniques, et dans lequel ladite distance minimale prédéterminée d est déterminée en fonction d'exigences réglementaires, et est comprise dans la plage de 2 à 5 mm, et **en ce que** le dispositif à LED (2) comprend en outre une interface de communication non galvanique (16) configurée pour réaliser un canal de communication bidirectionnel entre des circuits haute tension et des circuits électroniques basse tension sur lesdites première et seconde PCB respectivement, dans lequel l'interface de communication non galvanique (16) est intercalée entre les composants desdits circuits électroniques basse tension et haute tension, sur lesdites première et seconde PCB, respectivement.

2. Dispositif à LED (2) selon la revendication 1, dans lequel les formations tridimensionnelles sont adaptées pour coopérer entre elles de telle sorte que des formations hautes sur l'une des PCB présentent une extension vers des formations basses sur l'autre PCB à des positions correspondantes, c.-à-d. entre des formations hautes sur l'autre PCB.

3. Dispositif à LED (2) selon la revendication 1 ou 2, dans lequel ladite interface de communication non galvanique est une interface de communication optique (16) configurée pour réaliser un canal de communication optique bidirectionnel entre les circuits haute tension et des circuits électroniques basse tension sur lesdites première et seconde PCB, respectivement.

4. Dispositif à LED (2) selon l'une quelconque des revendications 1 à 3, dans lequel ladite seconde PCB (8) comprend des circuits prenant en charge la fonctionnalité DALI (Digital Addressable Lighting Interface - interface d'éclairage adressable numérique).

5. Dispositif à LED (2) selon l'une quelconque des revendications 1 à 4, dans lequel ladite première PCB comprend un élément de contact haute tension (18) structuré pour recevoir une puissance de commande haute tension par exemple 230 V. C.A., avec ledit dispositif à LED par l'intermédiaire d'un câble de connexion (20).

6. Dispositif à LED (2) selon l'une quelconque des revendications 1 à 5, comprenant un dispositif de montage configuré pour permettre le montage d'un boîtier comprenant des éléments optiques et/ou réfléchissants (22) au niveau dudit dispositif à LED.
